# FASCICULE DE BREVET EUROPEEN

(11) **EP 2 893 584 B1**
(45) Date de publication et mention de la délivrance du brevet: **27.09.2017**
(21) Numéro de dépôt: 13762183.5
(22) Date de dépôt: 23.08.2013
(51) Int. Cl.: H01M 6/18, C23C 14/34, H01M 10/052, H01M 10/0562

(54) **PROCÉDÉ POUR LA RÉALISATION D'UN ÉLECTROLYTE À BASE DE LITHIUM POUR MICRO-BATTERIE SOLIDE**
VERFAHREN ZUR HERSTELLUNG EINES ELEKTROLYTEN AUF LITHIUMBASIS FÜR EINE FESTSTOFFMIKROBATTERIE
METHOD FOR PRODUCING A LITHIUM-BASED ELECTROLYTE FOR A SOLID MICROBATTERY

(30) Priorité: 07.09.2012 FR 1258405
(43) Date de publication de la demande: 15.07.2015
(73) Titulaire: Commissariat à l'Énergie Atomique et aux Énergies Alternatives, 75015 Paris (FR)
(72) Inventeur: MARTIN, Steve, F-38160 Saint Sauveur (FR); AMIRAN, Johnny, F-38690 Eydoche (FR); LE VAN-JODIN, Lucie, F-38000 Grenoble (FR); OUKASSI, Sami, F-38120 Saint Egreve (FR)
(74) Mandataire: Cabinet Laurent & Charras
(86) Numéro de dépôt international: PCT/FR2013/051961
(87) Numéro de publication internationale: WO 2014/037646

(56) Documents cités:
- EP-A1- 0 627 497
- WO-A2-2006/081004
- WO-A2-2010/068624
- US-A- 5 202 008
- US-A- 5 382 339
- US-A- 5 409 587
- US-A- 5 945 354
- US-B1- 6 168 696
- US-B1- 6 454 912

## Description

### DOMAINE DE L'INVENTION

L'invention concerne un procédé de réalisation d'un électrolyte solide par pulvérisation cathodique d'un matériau à base de lithium.

Le domaine de la présente invention concerne notamment la fabrication de micro-batteries solides, pouvant être utilisées pour alimenter des microsystèmes tels que des cartes à puces ou des étiquettes intelligentes par exemple.

### ETAT ANTERIEUR DE LA TECHNIQUE

Une micro-batterie « tout solide » est un composant électrochimique permettant de stocker de l'énergie. Ces batteries, dont l'épaisseur totale est inférieure à 15 micromètres, présentent la particularité d'avoir un électrolyte solide.

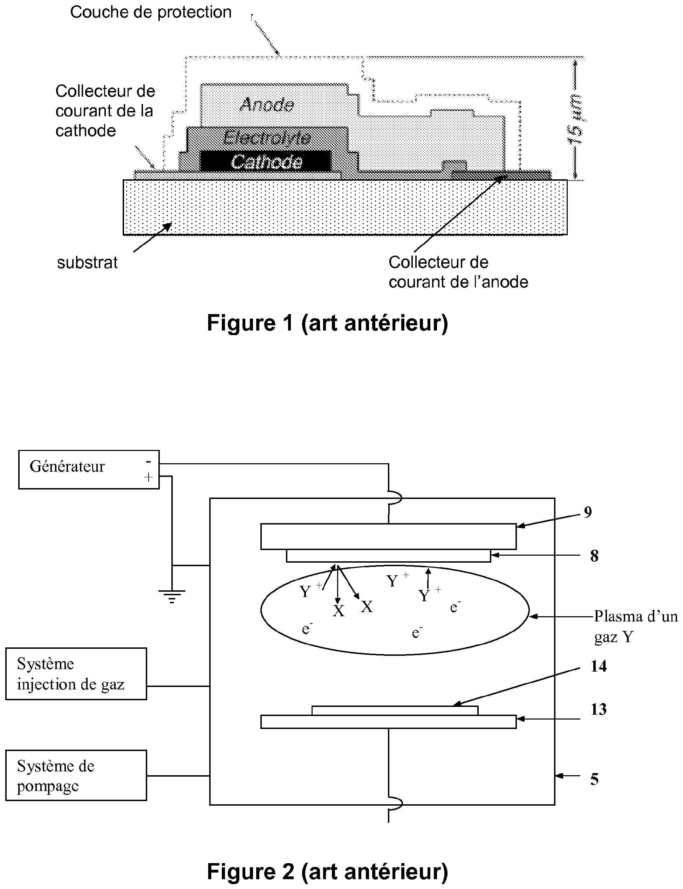

De manière générale, leur structure comprend un empilement des couches suivantes (figure 1) :
- un substrat ;
- un collecteur de courant pour la cathode ;
- un matériau de cathode ;
- un matériau électrolyte solide ;
- un matériau d'anode ;
- un collecteur de courant pour l'anode.

Les couches de matériaux peuvent être réalisées par dépôts successifs par CVD (selon l'acronyme anglo-saxon « *Chemical Vapor Deposition* ») éventuellement assistée par plasma (PE-CVD), ou par PVD (selon l'acronyme anglo-saxon « *Physical Vapor Deposition* ») et notamment par pulvérisation cathodique en ce qui concerne l'électrolyte.

Dans le cas de micro-batteries tout solide impliquant des ions lithium, ces derniers transitent entre l'anode et la cathode où ont lieu des réactions d'oxydo-réduction.

Ces réactions impliquent un échange d'électrons selon un circuit extérieur. En effet l'électrolyte séparant la cathode de l'anode, bloque le passage des électrons. Cet échange d'électrons permet ainsi d'assurer les cycles de charge/décharge de la micro-batterie.

Deux types de micro-batteries à base de lithium peuvent être distingués :
- les micro-batteries lithium, dont les ions lithium proviennent d'une anode en lithium métallique ;
- les micro-batteries Li-ion, dont les ions lithium sont issus d'un matériau d'électrode lithié (cathode ou anode).

Les batteries Li-ion peuvent être fabriquées soit à l'état chargé, soit à l'état déchargé. Dans le premier cas, le lithium est présent dans la couche d'anode au moment de la fabrication, alors qu'il est présent dans la couche de cathode dans le deuxième cas.

S'agissant de l'électrolyte solide, il peut être réalisé par dépôt par pulvérisation cathodique dans un réacteur présentant généralement une géométrie dite plane parallèle (figure 2). Dans cette technique, un matériau cible (8) ayant une composition chimique proche de celle souhaitée pour l'électrolyte, est fixé sur un support métallique (cathode (9)) dans un réacteur ou enceinte (5). Cette cathode (9) est polarisée négativement à l'aide d'un générateur électrique. Sous l'effet du champ électrique, le gaz (N₂ par exemple) présent au voisinage de la cible (8) est ionisé. Les ions positifs du gaz ionisé bombardent la cible et éjectent des atomes de la cible. Ces atomes se redéposent ensuite sur la surface opposée où est placé l'objet (14) à recouvrir, reposant sur un porte objet (13).

Afin de ne pas perturber la croissance du dépôt, rien ne sépare la cible du substrat à recouvrir d'électrolyte.

Néanmoins, le dépôt d'un électrolyte solide sur une électrode préalablement lithiée peut générer des problèmes spécifiquement liés à la technologie des accumulateurs au lithium.

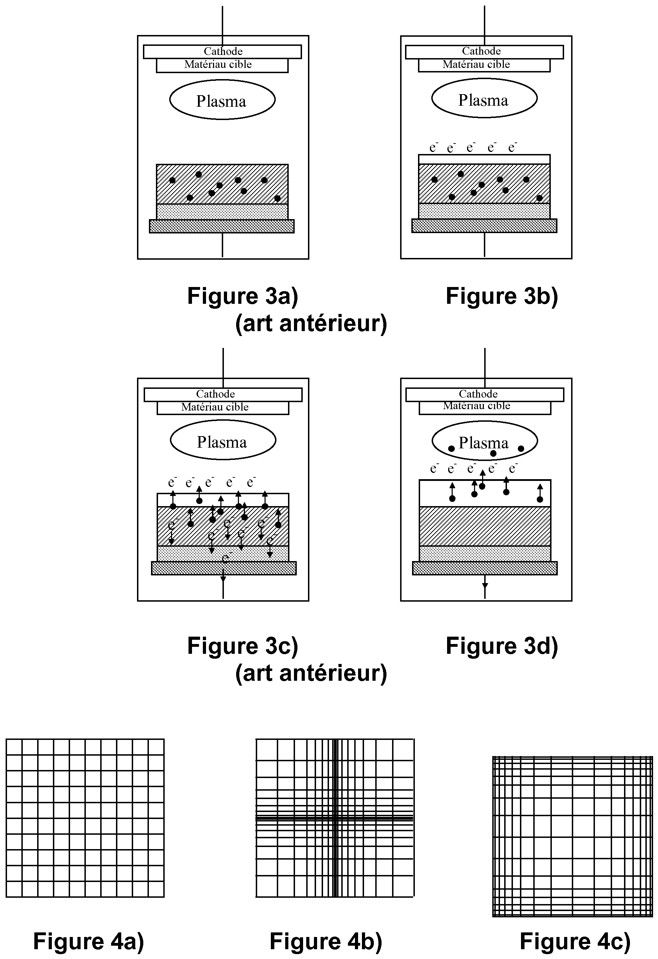

En effet, dans un procédé de dépôt par pulvérisation cathodique, lors du dépôt de la couche d'électrolyte sur une couche d'électrode lithiée (figure 3a), la surface de l'échantillon à recouvrir ne peut pas évacuer les électrons incidents (figure 3b). Par conséquent, elle se charge négativement jusqu'à atteindre un potentiel dit flottant, en équilibre avec le potentiel du plasma (figure 3b). La présence de charges négatives en surface a pour effet d'attirer le lithium, présent dans l'électrode lithiée. Ainsi, le lithium diffuse à travers l'électrolyte en cours de croissance, en direction de la surface en contact avec le plasma. Simultanément, les électrons, créés par la désinsertion des ions lithium Li⁺, sont évacués de l'électrode lithiée via le porte-substrat (figure 3c). L'excès de lithium en surface de l'électrolyte est ré-éjecté dans le plasma (figure 3d). Ce phénomène de « déplétion » appauvrit la structure en lithium, et entraine donc une baisse des performances électrochimiques.

Le phénomène de déplétion intervient durant le dépôt de l'électrolyte solide. Il dépend :
- des matériaux lithiés de l'électrode. En effet, plus le potentiel de l'électrode lithiée est élevé par rapport au lithium métallique, moins le phénomène sera prononcé. Par conséquent, les micro-batteries de l'art antérieur comprennent généralement une cathode en oxyde de cobalt lithié (LiCoO₂) qui présente un potentiel moins important que notamment une cathode à base de LiV₂O₅, SiLi, GeLi, Li₄Ti₅O₁₂, LiTiOS, LiTiS₂.
- de la vitesse de diffusion du lithium au sein du matériau d'électrode lithié. Plus le lithium diffuse rapidement dans le matériau, plus la micro-batterie se déchargera rapidement, éventuellement intégralement avant le dépôt de l'électrolyte.
- de la géométrie du réacteur dans lequel l'électrolyte est fabriqué. En effet, le potentiel flottant qu'acquiert une pièce plongée dans une enceinte plasma dépend des conditions d'excitation électrique de ce plasma (pression, puissance, nature des gaz...), mais aussi de la géométrie de l'enceinte de dépôt.
- de l'architecture de l'empilement comprenant l'enchainement cathode/électrolyte/ anode. Les procédés de fabrication de batteries de l'art antérieur peuvent mettre en oeuvre les techniques dites de « *shadow mask* », ou de pochoir, sur des substrats isolants (polyamide, PEN, borosilicate, mica...). Ces procédés permettent de réaliser plusieurs batteries de faibles dimensions (typiquement < 10 cm²) simultanément dans un même réacteur de dépôt. Dans ces procédés, l'électrode lithiée sur laquelle l'électrolyte est déposé, est électriquement isolée du reste du bâtit de dépôt. Ainsi, les électrons libérés lors de l'éventuelle désinsertion du lithium de l'électrode lithiée, restent confinés dans cette dernière, limitant de fait le processus de déplétion.

US5945354 décrit un procédé permettant de réduire la quantité de particules déposées sur un substrat semi-conducteur à l'issue d'étapes de modification de ce substrat. Le problème que se propose de résoudre la présente invention concerne notamment la réalisation d'une couche d'électrolyte solide à base de lithium tout en évitant le phénomène de déplétion, c'est-à-dire l'accumulation de charges négatives à la surface de l'échantillon lors d'un dépôt de matériau électrolyte solide.

### EXPOSE DE L'INVENTION

Le Demandeur a mis au point un procédé de réalisation d'un électrolyte solide par mise en oeuvre de la technique de pulvérisation cathodique.

La pulvérisation cathodique permet de déposer une couche mince de matériau sur un substrat. La synthèse de l'électrolyte solide implique la condensation sur le substrat d'un matériau cible vaporisé dans une enceinte (réacteur), éventuellement en présence d'autres éléments chimiques.

L'invention consiste, dans un procédé de pulvérisation cathodique, notamment à positionner une grille conductrice électronique entre l'échantillon à recouvrir et la cathode sur laquelle est placée la cible à pulvériser. La grille permet ainsi de faire écran aux charges électroniques négatives (électrons) générées par le plasma, de manière à limiter leur accumulation sur la surface de l'électrolyte en croissance.

Plus précisément, l'invention concerne un procédé de réalisation d'un électrolyte solide à base de lithium pour micro-batterie tout solide, par pulvérisation cathodique d'un matériau cible à base de lithium sur un objet reposant sur un porte-substrat. Dans ce procédé, une grille en matériau conducteur électrique dépourvu de lithium, est intercalée entre le matériau cible à base de lithium et l'objet. En outre, la grille est électriquement connectée au porte-substrat.

La grille en matériau conducteur électrique ne comprend pas de lithium. Elle peut avantageusement être réalisée au moyen d'au moins un métal choisi dans le groupe comprenant le titane, l'aluminium, l'acier inoxydable, le tungstène, le platine, le cuivre, et les alliages à base de ces métaux.

En ce qui concerne la position de la grille par rapport à l'objet, elle est préférentiellement positionnée à une distance comprise entre 1 et 100 millimètres par rapport à l'objet sur lequel l'électrolyte est formé, de préférence entre 5 et 50 millimètres, encore plus avantageusement 20 millimètres.

Dans le dispositif, ou réacteur ou enceinte, utilisé pour mettre en oeuvre le procédé de l'invention, il est préférable que la distance entre la grille et le substrat soit ajustée de manière à minimiser l'effet d'ombrage lié à la grille tout en conservant une différence de potentiel faible entre les deux interfaces de l'électrolyte en croissance. En effet, lorsque la grille est trop proche de la surface de l'objet à recouvrir, la couche d'électrolyte déposée présentera le même motif que celui de la grille. Dans ce cas, la grille peut ainsi agir comme un masque qui empêche un dépôt homogène sur l'intégralité de la surface. En revanche, lorsque la grille est trop éloignée de la surface de l'objet, l'effet technique procuré par la grille, à savoir la formation d'un écran, peut être relativement amoindri voire annulé.

En outre, l'épaisseur de la grille est avantageusement inférieure à 10 millimètres, de manière à ne pas collimater les espèces. En d'autres termes, le dépôt de l'électrolyte sur l'objet est réalisé de manière homogène sur l'intégralité de la surface de l'objet à recouvrir, et non selon les motifs de la grille.

Préférentiellement, l'épaisseur de la grille peut être comprise entre 50 et 500 micromètres, de préférence de 100 ou 250 micromètres, plus avantageusement encore de l'ordre de 200 micromètres.

La grille est constituée de fils pouvant définir au moins un motif se répétant éventuellement. Les fils peuvent aussi présenter des épaisseurs ou diamètres différents.

Selon un mode de réalisation particulier, la grille peut être constituée d'une pluralité de fils s'étendant selon au moins deux directions, avantageusement deux directions sensiblement perpendiculaires. Le diamètre ou l'épaisseur des fils peut être avantageusement compris entre 50 et 500 micromètres, de préférence de 100 ou 250 micromètres, plus avantageusement encore de l'ordre de 200 micromètres.

La grille, vue de dessus, peut avantageusement présenter au moins deux axes de symétrie.

La forme de la grille peut varier ; elle peut notamment être de forme rectangulaire, carrée, ovale, circulaire. En fait, la forme et les dimensions de la grille peuvent être ajustées en fonction de l'objet à recouvrir d'électrolyte solide. Elles sont telles que la surface principale de la grille est avantageusement au moins égale à la surface à recouvrir dudit objet.

Dans le cas où la grille présente une pluralité de fils se croisant, ces croisements de fils n'engendrent préférentiellement pas de surépaisseur. Quoi qu'il en soit, par épaisseur de la grille, on entend, l'épaisseur maximale et non l'épaisseur moyenne. Par conséquent, l'épaisseur de la grille et l'épaisseur du ou des fils ne sont pas nécessairement identiques.

S'agissant des dimensions de la grille, sa longueur et sa largeur, elles dépendent également du réacteur dans lequel est mis en oeuvre le procédé.

Dans le cas où la grille comprend plusieurs fils s'étendant selon une même direction, ils sont avantageusement espacés les uns des autres d'une distance inter fils comprise entre 0,5 millimètres et 2 centimètres, avantageusement de 2 millimètres. Cette distance inter fils entre deux fils consécutifs peut varier au sein d'une même grille.

La grille peut donc également comprendre plusieurs distances inter fils.

En outre, la grille peut également comprendre des motifs concentriques.

Comme déjà dit, la grille est intercalée entre le matériau cible à base de lithium, c'est-à-dire la cible de matériau d'électrolyte, et l'objet sur lequel l'électrolyte est déposé. Cet objet peut comprendre, successivement en direction du porte-substrat, une électrode, un collecteur de courant, et éventuellement un substrat.

L'objet est de manière avantageuse une électrode, encore plus avantageusement une électrode lithiée.

Comme déjà précisé, la grille est électriquement connectée au porte-substrat. Elle peut également être connectée au substrat et/ou au collecteur de courant et/ou à l'électrode. Selon un mode de réalisation particulier, la grille peut donc être connectée au porte-substrat, au substrat, au collecteur de courant, et à l'électrode.

Selon un autre mode de réalisation particulier, la connexion électrique entre la grille et au moins le porte substrat est assurée par un anneau métallique. Par anneau métallique, on entend un moyen pour assurer la connexion électrique. Cet anneau peut être en un matériau choisi dans le groupe comprenant le titane, l'acier inoxydable, le tungstène, le molybdène, le cuivre, le platine, et leurs mélanges.

De manière générale, le précurseur de lithium ou matériau cible à base de lithium, mis en oeuvre dans le procédé de l'invention peut notamment être un matériau solide à base de lithium choisi dans le groupe comprenant notamment le Li₃PO₄., le LiSiPON, le LiGePS, et le LiSON.

Ce matériau cible d'électrolyte, à base de lithium, se présente généralement sous la forme d'une couche préalablement formée ou déposée sur la cathode du dispositif de pulvérisation cathodique selon les techniques de l'art antérieur faisant partie des connaissances de l'homme du métier.

Outre le lithium, l'électrolyte lithié formé selon le procédé - objet de l'invention, peut contenir les éléments tels que le phosphore, l'azote, l'oxygène, le silicium, le titane, le lanthane, le germanium et leurs mélanges. Par exemple, la présence d'azote peut permettre d'augmenter la conductivité ionique de l'électrolyte.

Ainsi, selon un mode de réalisation particulier, la pulvérisation cathodique peut être réalisée en présence d'azote pour former un électrolyte comprenant de l'azote.

Par exemple, le matériau d'électrolyte déposé sur l'objet par mise en oeuvre du procédé de l'invention, peut notamment être le LiPON (« *Lithium Phosphorous OxyNitride* »), le LiSiPON (« *Nitrogen-incorporated Lithium SilicoPhosphate* »), ou le LiSON («*Lithium Sulfur Oxynitride* »).

S'agissant des collecteurs de courant, ils sont avantageusement métalliques et peuvent être, par exemple, à base de titane, tungstène, nickel, platine, cuivre, et or.

Le substrat peut être avantageusement en silicium ; en métal tel que le titane, l'acier inoxydable, le nickel, ou le tungstène ; en borosilicate ; en quartz, en MICA ; de nature polymérique (polyimide, PEN).

Le collecteur de courant métallique peut être avantageusement constitué d'une couche de titane, tungstène, platine, ou cuivre.

En outre, le porte substrat peut notamment être en métal ou céramique.

L'objet de la présente invention concerne également l'électrolyte solide obtenu par mise en oeuvre du procédé - objet de l'invention. Font également partie de la présente invention l'objet, ou l'électrode, sur lequel l'électrolyte a été déposé selon le procédé décrit ci-avant, mais également la micro-batterie comprenant cet électrolyte solide, cet objet, ou cette électrode, comprenant l'électrolyte.

Le dispositif, c'est-à-dire le réacteur utilisé pour mettre en oeuvre le procédé de préparation d'un électrolyte lithié par pulvérisation cathodique décrit ci-avant, fait également partie de la présente invention.

L'invention et les avantages qui en découlent ressortiront mieux des figures et exemples suivants donnés afin d'illustrer l'invention et non de manière limitative.

### DESCRIPTION DES FIGURES

La figure 1 illustre la structure d'une micro batterie de l'art antérieur.
La figure 2 représente un réacteur de dépôt par pulvérisation cathodique sous vide selon l'art antérieur mettant en oeuvre la technique de pulvérisation cathodique.
La figure 3 illustre les étapes de déplétion de lithium lors du dépôt de l'électrolyte sur une électrode lithiée selon les procédés de l'art antérieur mettant en oeuvre la technique de pulvérisation cathodique.
La figure 4 concerne des exemples de structures de la grille utilisée dans le procédé de la présente invention.
La figure 5 illustre un dispositif dans lequel est mis en oeuvre un mode de réalisation particulier du procédé objet de la présente invention.

### DESCRIPTION DETAILLEE DE L'INVENTION

Le procédé - objet de l'invention met en oeuvre une grille dont plusieurs exemples de structures possibles sont illustrés sur les figures 4a, 4b, et 4c. Toutefois, ces exemples ne limitent en rien la présente invention.

Ces trois exemples représentent tous une grille comprenant des fils s'étendant selon deux directions substantiellement perpendiculaires.

La structure de la grille peut être la conséquence de contraintes liées notamment à la géométrie de la cathode du dispositif de pulvérisation cathodique. En effet, la densité ainsi que l'énergie des espèces générées peuvent varier en fonction de la cathode du dispositif. La position de l'objet à recouvrir peut également impacter le dépôt de l'électrolyte solide.

Ces contraintes sont également présentes dans le cas d'un dépôt par pulvérisation cathodique, de type « *magnetron sputtering* » pour lequel la cathode comprend un aimant.

La grille représentée par la figure 4a comprend un seul espacement inter-fils quelle que soit la direction des fils. Elle est adaptée à un dispositif ou réacteur, dans lequel les lignes de champ électrique créent une densité de charges électroniques homogène, à la surface de l'objet à recouvrir d'électrolyte.

La grille représentée par la figure 4b est plus adaptée à un réacteur dans lequel les lignes de champ favorisent la formation d'une densité électronique hétérogène, au centre de la surface à recouvrir. Les fils constituant la grille sont ainsi concentrés au centre de la grille. Par conséquent, selon ce mode de réalisation, l'espacement entre deux fils consécutifs, n'est pas régulier. La distance inter-fils peut varier entre son centre et son bord, en fonction de la géométrie du réacteur.

En revanche, dans le cas où la densité d'espèces chargées est plus importante sur les bords de la surface à recouvrir, la grille du type de celle représentée par la figure 4c est préférable.

Les motifs de la grille sont avantageusement à l'image de la densité électronique créée. La grille permet ainsi de moduler le potentiel en surface de la couche d'électrolyte en croissance, de manière à ce qu'il soit le même que celui de la face opposée (en contact avec l'objet).

Par conséquent, la grille permet de limiter l'accumulation de charges négatives en surface et d'atténuer ainsi la déplétion du lithium.

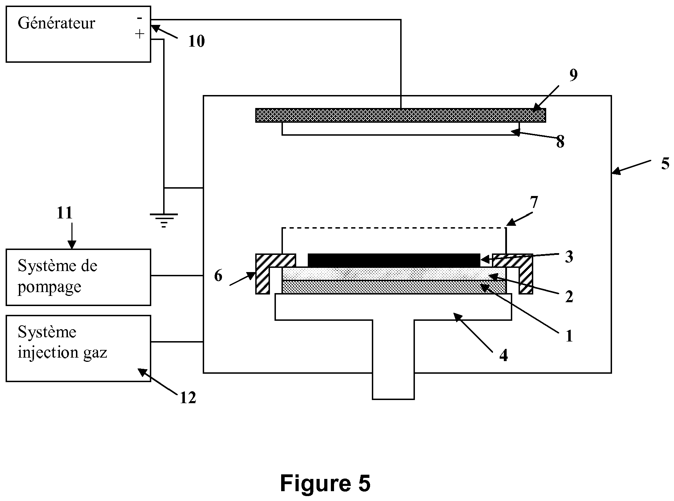

La figure 5 représente un dispositif permettant de mettre en oeuvre un mode de réalisation particulier du procédé - objet de la présente invention. Dans ce dispositif, la grille métallique est connectée électriquement au porte-substrat au moyen d'un anneau conducteur électrique.

Cette figure concerne la préparation d'un électrolyte solide en LiPON, dans une enceinte à vide (5), l'objet à recouvrir d'électrolyte LiPON étant positionné sur un porte-substrat (4).

L'objet comprend, en direction du porte-substrat, une électrode lithiée (3), un collecteur de courant métallique (2), et un substrat (1).

Le substrat peut être avantageusement en silicium mono-, en métal tel que le titane ou l'acier inoxydable, ou de nature polymérique (polyimide, PEN).

Le collecteur de courant métallique peut être avantageusement constitué d'une couche de titane, tungstène, platine, ou cuivre.

L'électrode lithiée (3) est constituée d'un matériau comportant du lithium (3).

Le porte-substrat (4) et l'objet (électrode (3)) sont connectés électriquement au moyen d'un anneau métallique (6) de manière à assurer une continuité électrique entre l'anneau (6) et le collecteur de courant métallique (2).

Une grille métallique (7) est fixée/connectée à cet anneau (6) de manière à garantir une continuité électrique entre les deux pièces. Cette dernière est en acier inoxydable de type 316L. Elle possède une maille carrée de 2 mm, c'est-à-dire une distance inter-fils de 2 mm selon deux directions perpendiculaires. L'épaisseur du fil en acier inoxydable 316L est de 200µm.

La grille est positionnée à une distance de 1.5 cm par rapport à l'objet à recouvrir d'électrolyte LiPON.

Parallèlement, une couche de matériau cible de composition chimique Li₃PO₄ (8) est collée à la cathode (9) du réacteur (5).

La cathode est soumise à l'application d'un champ électrique radio fréquence grâce à l'emploi d'un générateur électrique (10).

En outre, un système de pompage (11) est relié à l'enceinte (5) de dépôt afin de pouvoir effectuer le vide.

Un système d'injection des (12) gaz permet d'injecter un débit d'azote contrôlé dans l'enceinte (5).

Un électrolyte solide LIPON est ainsi déposé sur l'électrode lithiée (3) tout en limitant ou annulant le phénomène de déplétion.

## Revendications

1. Procédé pour la réalisation d'un électrolyte solide à base de lithium pour une micro-batterie solide, par pulvérisation cathodique d'un matériau cible à base de lithium (8) dans un dispositif de pulvérisation cathodique comprenant une cathode (9) sur laquelle repose le matériau cible à base de lithium (8) et un objet reposant sur un porte-substrat (4), selon lequel :
- on pulvérise le matériau cible à base de lithium ;
- on forme un électrolyte solide à base de lithium sur l'objet ;
**caractérisé en ce que**
- préalablement à la pulvérisation du matériau cible à base de lithium, on intercale une grille (7) réalisée en un matériau conducteur électrique dépourvu de lithium, entre l'objet et le matériau cible à base de lithium, et
- on connecte électriquement la grille (7) le porte-substrat.

2. Procédé pour la réalisation d'un électrolyte solide selon la revendication 1, ***caractérisé* en ce que** la grille (7) en matériau conducteur électrique est réalisée en un métal choisi dans le groupe comprenant le titane, l'acier inoxydable, le tungstène, aluminium, le platine, le cuivre, et leurs alliages et mélanges.

3. Procédé pour la réalisation d'un électrolyte solide selon la revendication 1 ou 2, ***caractérisé* en ce que** la grille (7) est positionnée à une distance comprise entre 1 et 100 millimètres par rapport à l'objet, de préférence entre 5 et 50 millimètres.

4. Procédé pour la réalisation d'un électrolyte solide selon l'une des revendications 1 à 3, ***caractérisé* en ce que** le matériau cible à base de lithium est un matériau solide à base de lithium choisi dans le groupe comprenant le Li₃PO₄, le LiSiPON, le LiGePS, et le LiSON.

5. Procédé pour la réalisation d'un électrolyte solide selon l'une des revendications 1 à 4, ***caractérisé* en ce que** la pulvérisation cathodique est réalisée en présence d'azote.

6. Procédé pour la réalisation d'un électrolyte solide selon l'une des revendications 1 à 5, ***caractérisé* en ce que** la grille (7) présente une épaisseur inférieure à 10 millimètres, de préférence entre 50 et 500 micromètres.

7. Procédé pour la réalisation d'un électrolyte solide selon l'une des revendications 1 à 6, ***caractérisé* en ce que** la grille (7) est constituée d'une pluralité de fils s'étendant selon au moins deux directions.

8. Procédé pour la réalisation d'un électrolyte solide selon la revendication 7, ***caractérisé* en ce que** les fils selon une même direction sont espacées d'une distance comprise entre 0,5 millimètres et 2 centimètres, avantageusement de 2 millimètres.

9. Procédé pour la réalisation d'un électrolyte solide selon l'une des revendications 1 à 8, ***caractérisé* en ce que** l'objet comprend successivement, en direction du porte-substrat, une électrode lithiée (3), un collecteur de courant (2), et un substrat (1).

10. Procédé pour la réalisation d'un électrolyte solide selon la revendication 9, ***caractérisé* en ce que** la grille (7) est également électriquement connectée au substrat et/ou au collecteur de courant et/ou à l'électrode lithiée.

11. Procédé pour la réalisation d'un électrolyte solide selon l'une des revendications 1 à 10, ***caractérisé* en ce que** la connexion électrique entre la grille et au moins le porte-substrat est assurée par un anneau métallique (6).

12. Procédé pour la réalisation d'un électrolyte solide selon l'une des revendications 1 à 11, ***caractérisé* en ce que** le matériau d'électrolyte est choisi dans le groupe comprenant le LiPON, le LiSiPON, et le LiSON.

13. Electrode comprenant l'électrolyte obtenu selon le procédé objet de l'une des revendications 1 à 12.

14. Micro-batterie comprenant l'électrode objet de la revendication 13.

## Patentansprüche

1. Verfahren zur Herstellung eines festen Elektrolyts auf Lithium-Basis für eine feste Mikrobatterie, durch Kathodenzerstäubung eines Zielmaterials auf Lithium-Basis (8) in einer Kathodenzerstäubungsvorrichtung mit einer Kathode (9), auf der das Zielmaterial auf Lithium-Basis (8) liegt und mit einem Objekt, das auf einem Substratträger (4) liegt, dem zufolge:
- das Zielmaterial auf Lithium-Basis pulverisiert wird;
- ein festes Elektrolyt auf Lithium-Basis auf dem Objekt gebildet wird;
***dadurch gekennzeichnet, dass***
- vor der Zerstäubung des Zielmaterials auf Lithium-Basis ein Gitter (7), das aus einem Lithium- freien elektrisch leitendem Material besteht, zwischen dem Objekt und dem Zielmaterial auf Lithium-Basis eingeschoben wird und
- das Gitter (7) mit dem Substratträger elektrisch verbunden wird.

2. Verfahren zur Herstellung eines festen Elektrolyts gemäß Anspruch 1, ***dadurch gekennzeichnet, dass*** das Gitter (7) aus elektrisch leitendem Material aus einem Metall besteht, das aus der Gruppe bestehend aus Titan, Edelstahl, Wolfram, Aluminium, Platin, Kupfer und ihren Legierungen und Mischungen ausgewählt wird.

3. Verfahren zur Herstellung eines festen Elektrolyts gemäß Anspruch 1 oder 2, ***dadurch gekennzeichnet, dass*** das Gitter (7) in einer Entfernung zwischen 1 und 100 Millimetern bezogen auf das Objekt, am besten zwischen 5 und 50 Millimetern, angeordnet ist.

4. Verfahren zur Herstellung eines festen Elektrolyts gemäß einem der Ansprüche 1 bis 3, ***dadurch gekennzeichnet, dass*** es sich bei dem Zielmaterial auf Lithium-Basis um einen festen Stoff auf Lithium-Basis handelt, der aus der Gruppe, die Li₃P0₄, LiSiPON, LiGePS und LiSON umfasst, ausgewählt wird.

5. Verfahren zur Herstellung eines festen Elektrolyts gemäß einem der Ansprüche 1 bis 4, ***dadurch gekennzeichnet, dass*** die Kathodenzerstäubung in Anwesenheit von Stickstoff stattfindet.

6. Verfahren zur Herstellung eines festen Elektrolyts gemäß einem der Ansprüche 1 bis 5, ***dadurch gekennzeichnet, dass*** das Gitter (7) eine Dicke von unter 10 Millimetern, am besten zwischen 50 und 500 Mikrometern, aufweist.

7. Verfahren zur Herstellung eines festen Elektrolyts gemäß einem der Ansprüche 1 bis 6, ***dadurch gekennzeichnet, dass*** das Gitter (7) aus zahlreichen Drähten besteht, die sich in mindestens zwei Richtungen erstrecken.

8. Verfahren zur Herstellung eines festen Elektrolyts gemäß Anspruch 7, ***dadurch gekennzeichnet, dass*** die Drähte, die in dieselbe Richtung verlaufen, einen Abstand zwischen 0,5 Millimetern und 2 Zentimetern, am besten von 2 Millimetern, haben.

9. Verfahren zur Herstellung eines festen Elektrolyts gemäß einem der Ansprüche 1 bis 8, ***dadurch gekennzeichnet, dass*** das Objekt, in Richtung des Substratträgers aufeinander folgend, eine Lithium-Elektrode (3), einen Strohmabnehmer (2) und ein Substrat (1) umfasst.

10. Verfahren zur Herstellung eines festen Elektrolyts gemäß Anspruch 9, ***dadurch gekennzeichnet, dass*** das Gitter (7) auch elektrisch mit dem Substrat und/ oder dem Stromabnehmer und/ oder der Lithium-Elektrode verbunden ist.

11. Verfahren zur Herstellung eines festen Elektrolyts gemäß einem der Ansprüche 1 bis 10, ***dadurch gekennzeichnet, dass*** die elektrische Verbindung zwischen dem Gitter und mindestens dem Substratträger durch einen Metallring (6) gewährleistet wird.

12. Verfahren zur Herstellung eines festen Elektrolyts gemäß einem der Ansprüche 1 bis 11, **dadurch gekennzeichnet, dass** das Elektrolytmaterial ausgewählt wird aus der Gruppe, die LiPON, LiSiPON und LiSON umfasst.

13. Elektrode, die das Elektrolyt enthält, das nach dem Verfahren, das Gegenstand eines der Ansprüche 1 bis 12 ist, erhalten wurde.

14. Mikrobatterie, die die Elektrode umfasst, die Gegenstand des Anspruchs 13 ist.

## Claims

1. Method of forming a solid lithium-based electrolyte for a solid microbattery, by cathode sputtering of a target lithium-based material (8) in a cathode sputtering device comprising a cathode (9) supporting the lithium-based target material (8) and an object supported by a substrate holder (4), wherein:
- the target lithium-based material is sputtered;
- a solid lithium-based electrolyte is formed on the object;
**characterized in that**:
- prior to the sputtering of the target lithium-based material, a grid (7) made of a lithium-free electrically-conductive material, is interposed between the object and the lithium-based target material, and
- the grid (7) and the substrate holder are electrically connected.

2. The solid electrolyte forming method of claim 1, ***characterized in that*** the grid (7) of electrically-conductive material is made of a metal selected from the group comprising titanium, stainless steel, tungsten, aluminum, platinum, copper, and alloys and mixtures thereof.

3. The solid electrolyte forming method of claim 1 or 2, ***characterized in that*** the grid (7) is positioned at a distance in the range from 1 to 100 millimeters from the object, preferably from 5 to 50 millimeters.

4. The solid electrolyte forming method of any of claims 1 to 3, ***characterized in that*** the lithium-based target material is a solid lithium-based material selected from the group comprising Li₃PO₄, LiSiPON, LiGePS, and LiSON.

5. The solid electrolyte forming method of any of claims 1 to 4, ***characterized in that*** the cathode sputtering is performed in the presence of nitrogen.

6. The solid electrolyte forming method of any of claims 1 to 5, ***characterized in that*** the grid (7) has a thickness smaller than 10 millimeters, preferably from 50 to 500 micrometers.

7. The solid electrolyte forming method of any of claims 1 to 6, ***characterized in that*** the grid (7) is made of a plurality of wires extending along at least two directions.

8. The solid electrolyte forming method of claim 7, ***characterized in that*** the wires along a same direction are spaced apart by a distance in the range from 0.5 millimeters to 2 centimeters, advantageously 2 millimeters.

9. The solid electrolyte forming method of any of claims 1 to 8, ***characterized in that*** the object successively comprises, towards the substrate holder, a lithiated electrode (3), a current collector (2), and a substrate (1).

10. The solid electrolyte forming method of claim 9, ***characterized in that*** the grid (7) is also electrically connected to the substrate and/or to the current collector and/or to the lithiated electrode.

11. The solid electrolyte forming method of any of claims 1 to 10, ***characterized in that*** the electric connection between the grid and at least the substrate holder is provided by a metal ring (6).

12. The solid electrolyte forming method of any of claims 1 to 11, ***characterized in that*** the electrolyte material is selected from the group comprising LiPON, LiSiPON, and LiSON.

13. An electrode comprising the electrolyte obtained according to the method of any of claims 1 to 12.

14. A microbattery comprising the electrode of claim 13.
